# FASCICULE DE BREVET EUROPEEN

(11) **EP 2 376 588 B1**
(45) Date de publication et mention de la délivrance du brevet: **11.03.2015**
(21) Numéro de dépôt: 10706701.9
(22) Date de dépôt: 13.01.2010
(51) Int. Cl.: C09K 5/04, F25B 30/02

(54) **PROCEDE DE TRANSFERT DE CHALEUR**
WÄRMEÜBERTRAGUNGSVERFAHREN
HEAT TRANSFER METHOD

(30) Priorité: 14.01.2009 FR 0950167
(43) Date de publication de la demande: 19.10.2011
(73) Titulaire: Arkema France, 92700 Colombes (FR)
(72) Inventeur: ABBAS, Laurent, F-69340 Francheville (FR); RACHED, Wissam, F-69007 Lyon (FR)
(74) Mandataire: Dang, Doris
(86) Numéro de dépôt international: PCT/FR2010/050045
(87) Numéro de publication internationale: WO 2010/081990

(56) Documents cités:
- FR-A- 2 653 863
- US-A- 5 788 886
- US-A- 5 866 029
- US-A1- 2002 003 224
- US-A1- 2007 023 729
- KOSMADAKIS G ET AL: "Comparative thermodynamic study of refrigerants to select the best for use in the high-temperature stage of a two-stage organic Rankine cycle for RO desalination" DESALINATION, ELSEVIER, AMSTERDAM, NL, vol. 243, no. 1-3, 1 juillet 2009 (2009-07-01), pages 74-94, XP026106949 ISSN: 0011-9164 [extrait le 2009-05-13]

## Description

La présente invention concerne un procédé de transfert de chaleur à l'aide d'une composition renfermant le pentafluoropropane et au moins un hydrocarbure. Elle a plus particulièrement pour objet l'utilisation d'une composition renfermant le pentafluoropropane et au moins un hydrocarbure dans les pompes à chaleur.

Les problèmes posés par les substances appauvrissant la couche d'ozone atmosphérique (ODP : ozone depletion potential) ont été traités à Montréal où a été signé le protocole imposant une réduction de la production et de l'utilisation des chlorofluorocarbures (CFC). Ce protocole a fait l'objet d'amendements qui ont imposé l'abandon des CFC et étendu la réglementation à d'autres produits.

L'industrie de la réfrigération et de la production d'air conditionné a beaucoup investi dans la substitution de ces fluides frigorigènes.

Dans l'industrie automobile, les systèmes de climatisation des véhicules commercialisés dans de nombreux pays sont passés d'un fluide frigorigène au chlorofluorocarbure (CFC-12) à celui de l'hydrofluorocarbure (1,1,1,2 tetrafluoroéthane : HFC-134a), moins nocif pour la couche d'ozone. Cependant, au regard des objectifs fixés par le protocole de Kyoto, le HFC-134a (GWP = 1300) est considéré comme ayant un pouvoir de réchauffement élevé. La contribution à l'effet de serre d'un fluide est quantifiée par un critère, le GWP (Global Warming Potentials) qui résume le pouvoir de réchauffement en prenant une valeur de référence de 1 pour le dioxyde de carbone.

Dans le domaine des pompes à chaleur, des substituts au dichlorotetrafluoroéthane (HCFC-114), utilisé dans des conditions de température de condensation élevée, ont été proposés. Ainsi, le document US 6814884 décrit une composition comprenant du 1,1,1,3,3-pentafluorobutane (HFC-365mfc) et au moins un composé choisi parmi le 1,1,1,2 tetrafluoroéthane, le pentafluoroéthane (HFC-125), le 1,1,1,3,3-pentafluoropropane (HFC-245fa) et le 1,1,1,2,3,3,3-heptafluoropropane (HFC-227ea). Cependant, ces compositions sont peu performantes car elles ont un grand glissement de température et une faible capacité calorifique (la capacité calorifique est inférieure à 60% par rapport au HCFC-114) ; en outre, la présence du HFC-227ea et HFC-125 conduit à un GWP élevé.

Le document US 5788886 divulgue des compositions de pentafluoropropane et un fluoropropane tels que le tetrafluoropropane, le trifluoropropane, le difluoropropane ou fluoropropane ; le 1,1,1,4,4,4-hexafluorobutane, (CF₃)₂CHCH₃ ; le 1,1,1,2,3,4,4,5,5,5-decafluoropentane ; un hydrocarbure tels que le butane, le cyclopropane, l'isobutane, le propane, le pentane ; ou le propylène ; ou le diméthyl éther. Ce document enseigne l'utilisation de ces compositions notamment en tant que réfrigérants, agents de nettoyage et agents d'expansion.

Des mélanges binaires azéotropiques ou quasi-azéotropiques sont également divulgués dans ce document. On peut citer notamment le mélange binaire du 1,1,1,3,3-pentafluoropropane et de pentane.

Le document US20070023729 divulgue des compositions de cyclopentane et un hydrofluorocarbure, par example le 1,1,1,3,3-pentafluoropropene. Ce document enseigne l'utilisation de ces compositions en tant que réfrigérants, agents de nettoyage et agents d'expansion.

Le document US 5672294 divulgue des compositions azéotropiques ou quasi-azéotropiques de 1,1,1,3,3-pentafluoropropane et au moins un hydrocarbure choisi parmi le n-, iso-, cyclo- pentane et le n-, iso-hexane. Il enseigne l'utilisation de ces compositions comme agent d'expansion dans la fabrication des mousses de polyuréthane et polysiocyanurate, ainsi que comme propulseur d'aérosol.

La demanderesse a maintenant découvert que des compositions renfermant du 1,1,1,3,3-pentafluoropropane et au moins un hydrocarbure choisi parmi le n-pentane, l'iso-pentane et le cyclo-pentane conviennent tout particulièrement comme fluide de transfert de chaleur dans les pompes à chaleur, en particulier les pompes à chaleur opérant à température de condensation élevée. En outre, ces compositions ont un ODP négligeable et un GWP inférieur à celui des fluides de transfert de chaleur existants.

Une pompe à chaleur est un dispositif thermodynamique permettant de transférer de la chaleur du milieu le plus froid vers le milieu le plus chaud. Les pompes à chaleur employées pour le chauffage sont dites à compression et le fonctionnement est basé sur le principe de cycle à compression de fluides, appelés fluides frigorigènes. Ces pompes à chaleur fonctionnent avec des systèmes à compression comportant un seul ou plusieurs étage(s). A un étage donné, lorsque le fluide frigorigène est comprimé et passe de l'état gazeux à l'état liquide, il se produit une réaction exothermique (condensation) qui produit de la chaleur. A l'inverse, si on détend le fluide en le faisant passer de l'état liquide à l'état gazeux, il se produit une réaction endothermique (évaporation), qui produit une sensation de froid. Tout repose donc sur le changement d'état d'un fluide utilisé en circuit fermé.

Chaque étage d'un système à compression comprend (i) une étape d'évaporation au cours de laquelle au contact des calories puisées dans l'environnement, le fluide frigorigène, grâce à son faible point d'ébullition, passe de l'état liquide à l'état de gaz, (ii) une étape de compression au cours de laquelle le gaz de l'étape précédente est porté à haute pression, (iii) une étape de condensation au cours de laquelle le gaz va transmettre sa chaleur au circuit chauffage ; le fluide frigorigène, toujours comprimé, redevient liquide et (iv) une étape de détente au cours de laquelle la pression du fluide est réduite. Le fluide est prêt pour une nouvelle absorption de calories de l'environnement froid.

La présente invention a pour objet un procédé de transfert de chaleur mettant en oeuvre un système à compression comportant au moins un étage comprenant successivement une étape d'évaporation d'un fluide frigorigène, une étape de compression, une étape de condensation dudit fluide à une température comprise entre 70 et 140°C, de préférence entre 95 et 125°C et une étape de détente dudit fluide caractérisé en ce que le fluide frigorigène comprend de 60 à 95 % en poids de 1,1,1,3,3-pentafluoropropane et de 5 à 40 % en poids d'au moins un hydrocarbure choisi parmi le n-pentane, l'iso-pentane et le cyclo-pentane.

De préférence, le fluide frigorigène comprend de 66 à 93 % en poids de 1,1,1,3,3-pentafluoropropane et de 7 à 34 % en poids d'au moins un hydrocarbure choisi parmi le n-pentane, l'iso-pentane et le cyclo-pentane.

L'hydrocarbure avantageusement préféré est l'iso-pentane.

Comme fluide frigorigène avantageusement préféré, on peut citer notamment celui comprenant :
- de 65 à 93 % en poids de 1,1,1,3,3-pentafluoropropane et de 7 % 35 % en poids de n-pentane ;
- de 70 à 90 % en poids de 1,1,1,3,3-pentafluoropropane et de 10 à 30 % en poids d' iso-pentane ; et
- de 70 à 90 % en poids de 1,1,1,3,3-pentafluoropropane et de 10 à 30 % en poids de cyclo-pentane.

Comme fluide frigorigène particulièrement préféré, on peut citer notamment celui comprenant :
- de 76 à 91 % en poids de 1,1,1,3,3-pentafluoropropane et de 9 % 24 % en poids de n-pentane ;
- de 75 à 85 % en poids de 1,1,1,3,3-pentafluoropropane et de 15 à 25 % en poids d' iso-pentane ; et
- de 72 à 80 % en poids de 1,1,1,3,3-pentafluoropropane et de 20 à 28 % en poids de cyclo-pentane.

Le fluide frigorigène utilisé dans le procédé selon la présente invention peut comprendre des lubrifiants tels que l'huile minérale, alkylbenzène, le polyalkylène glycol et le polyvinyl éther.

La présente invention a également pour objet un dispositif de pompe à chaleur renfermant un fluide frigorigène tel que décrit précédemment.

### PARTIE EXPERIMENTALE

Dans ce qui suit :
Evap P est la pression à l'évaporateur
Cond P est la pression au condenseur
T cond est la température de condensation
Te comp est la température entrée compresseur
Taux : le taux de compression
T sortie comp est la température à la sortie compresseur
COP : coefficient de performance et est défini, lorsqu'il s'agit d'une pompe à chaleur comme étant la puissance chaude utile fournie par le système sur la puissance apportée ou consommée par le système
CAP : capacité volumétrique, c'est la capacité calorifique par unité de volume (kJ/m³) % CAP ou COP c'est le rapport de la valeur du CAP ou COP du fluide par rapport à celui obtenu avec le HCFC-114.
A : 75 % en poids de HFC-365mfc et 25 % en poids de HFC-227ea.
B1 : 90 % en poids de HFC-245fa et 10 % en poids d'iso-pentane.
B2 : 85 % en poids de HFC-245fa et 15 % en poids d'iso-pentane.
B3 : 80 % en poids de HFC-245fa et 20 % en poids d'iso-pentane.
C1 : 90 % en poids de HFC-245fa et 10 % en poids de n-pentane.
C2 : 85 % en poids de HFC-245fa et 15 % en poids de n-pentane.
C3 : 80 % en poids de HFC-245fa et 20 % en poids de n-pentane.

### Exemple 1

Les performances du fluide frigorigène dans les conditions de fonctionnement de pompe à chaleur, avec la température à l'évaporateur maintenue à 50°C, à l'entrée du compresseur maintenue à 65°C et au condenseur à 120 °C, sont données ci-dessous. Pour le HCFC-114, la pression nominale de fonctionnement est de 20,8 bar, la capacité volumétrique est de 2690 kJ/m³ et le COP est de 3,3 dans les conditions de fonctionnement suivantes :
Rendement isentropique du compresseur : 80 %

| | Evap P (kPa) | Cond P (kPa) | Taux (p/p) | T sortie comp | CAP (KJ/m3) | COPc | % cap | % COPc |
|---|---|---|---|---|---|---|---|---|
| HCFC-114 | 447 | 2082 | 4,66 | 125 | 2690 | 3,3 | 100 | 100 |
| HFC-245fa | 343 | 1937 | 5,65 | 127 | 2487 | 3,5 | 92 | 105 |
| Isopentane | 205 | 1086 | 5,29 | 116 | 1522 | 3,6 | 57 | 110 |
| HFC-365mfc | 142 | 931 | 6,54 | 115 | 1201 | 3,6 | 45 | 110 |
| A | 177 | 1480 | 8,36 | 126 | 1405 | 3,1 | 52 | 93 |
| Pentane | 159 | 905 | 5,68 | 117 | 1278 | 3,7 | 47 | 112 |
| B1 | 393 | 2072 | 5,27 | 124 | 2650 | 3,4 | 99 | 102 |
| B2 | 409 | 2082 | 5,09 | 122 | 2719 | 3,4 | 101 | 103 |
| B3 | 411 | 2073 | 5,04 | 121 | 2724 | 3,4 | 101 | 103 |
| C1 | 357 | 2010 | 5,62 | 125 | 2592 | 3 | 96 | 105 |
| C2 | 355 | 2001 | 5,64 | 125 | 2581 | 3,5 | 96 | 105 |
| C3 | 340 | 1979 | 5,82 | 125 | 2497 | 3,4 | 93 | 104 |

### Exemple 2

Les performances du fluide frigorigène dans les conditions de fonctionnement de pompe à chaleur, avec la température à l'évaporateur maintenue à 80°C, à l'entrée du compresseur maintenue à 95°C et au condenseur à 120 °C , sont données ci-dessous.

Pour le HCFC-114, la pression nominale de fonctionnement est de 20,8 bar, la capacité volumétrique est de 5867 kJ/m³ et le COP est de 6,6 dans les conditions de fonctionnement suivantes :
Rendement isentropique du compresseur : 80 %

| | Evap P (kPa) | Cond P (kPa) | Taux (P/P) | T sortie comp | CAP (KJ/m3) | COPc | % CAP | % COPc |
|---|---|---|---|---|---|---|---|---|
| HCFC-114 | 930 | 2082 | 2,24 | 130 | 5867 | 6,6 | 100 | 100 |
| HFC-245fa | 788 | 1937 | 2,46 | 130 | 5810 | 6,8 | 99 | 103 |
| Isopentane | 456 | 1086 | 2,38 | 123 | 3457 | 7,2 | 59 | 109 |
| HFC-365mfc | 352 | 931 | 2,65 | 123 | 3021 | 7,2 | 51 | 110 |
| A) | 436 | 1480 | 3,40 | 133 | 3552 | 5,6 | 61 | 84 |
| Pentane | 367 | 905 | 2,46 | 124 | 2957 | 7,3 | 50 | 110 |
| B1 | 881 | 2072 | 2,35 | 128 | 6104 | 6,8 | 104 | 103 |
| B2 | 901 | 2082 | 2,31 | 127 | 6190 | 6,9 | 105 | 104 |
| B3 | 894 | 2073 | 2,32 | 127 | 6140 | 6,8 | 105 | 104 |
| C1 | 820 | 2010 | 2,45 | 129 | 6061 | 7 | 103 | 104 |
| C2 | 813 | 2001 | 2,46 | 129 | 6026 | 6,8 | 103 | 103 |
| C3 | 780 | 1979 | 2,54 | 130 | 5826 | 6,6 | 99 | 101 |

## Revendications

1. Procédé de transfert de chaleur mettant en oeuvre un système à compression comportant au moins un étage comprenant successivement une étape d'évaporation d'un fluide frigorigène, une étape de compression, une étape de condensation dudit fluide à une température comprise entre 70 et 140°C, de préférence entre 95 et 125°C et une étape de détente dudit fluide **caractérisé en ce que** le fluide frigorigène comprend de 60 à 95 % en poids de 1,1,1,3,3-pentafluoropropane et de 5 à 40 % en poids d'au moins un hydrocarbure choisi parmi le n-pentane, l'iso-pentane et le cyclo-pentane.

2. Procédé selon la revendication 1 **caractérisé en ce que** le fluide frigorigène comprend 66 à 93 % en poids de 1,1,1,3,3-pentafluoropropane et de 7 à 34 % en poids d'au moins un hydrocarbure choisi parmi le n-pentane, l'iso-pentane et le cyclo-pentane.

3. Procédé selon la revendication 1 ou 2 **caractérisé en ce que** l'hydrocarbure est l'iso-pentane.

4. Procédé selon l'une quelconque des revendications 1 à 3 **caractérisé en ce que** le fluide frigorigène comprend de 76 à 91 % en poids de 1,1,1,3,3-pentafluoropropane et de 9 % 24 % en poids de n-pentane .

5. Procédé selon l'une quelconque des revendications 1 à 3 **caractérisé en ce que** le fluide frigorigène comprend de 75 à 85 % en poids de 1,1,1,3,3-pentafluoropropane et de 15 à 25 % en poids d' iso-pentane.

6. Procédé selon l'une quelconque des revendications 1 à 3 **caractérisé en ce que** le fluide frigorigène comprend de 72 à 80 % en poids de 1,1,1,3,3-pentafluoropropane et de 20 à 28 % en poids de cyclo-pentane.

## Patentansprüche

1. Verfahren zur Wärmeübertragung unter Verwendung eines Verdichtungssystems mit mindestens einer Stufe, die nacheinander einen Schritt des Verdampfens eines Kältemittelfluids, einen Schritt des Verdichtens, einen Schritt des Kondensierens des Fluids bei einer Temperatur zwischen 70 und 140°C, vorzugsweise zwischen 95 und 125°C, und einen Schritt des Entspannens des Fluids umfasst, **dadurch gekennzeichnet, dass** das Kältemittelfluid 60 bis 95 Gew.-% 1,1,1,3,3-Pentafluorpropan und 5 bis 40 Gew.-% mindestens eines Kohlenwasserstoffs, der aus n-Pentan, Isopentan und Cyclopentan ausgewählt ist, umfasst.

2. Verfahren nach Anspruch 1, **dadurch gekennzeichnet, dass** das Kältemittelfluid 66 bis 93 Gew.-% 1,1,1,3,3-Pentafluorpropan und 7 bis 34 Gew.-% mindestens eines Kohlenwasserstoffs, der aus n-Pentan, Isopentan und Cyclopentan ausgewählt ist, umfasst.

3. Verfahren nach Anspruch 1 oder 2, **dadurch gekennzeichnet, dass** es sich bei dem Kohlenwasserstoff um Isopentan handelt.

4. Verfahren nach einem der Ansprüche 1 bis 3, **dadurch gekennzeichnet, dass** das Kältemittelfluid 76 bis 91 Gew.-% 1,1,1,3,3-Pentafluorpropan und 9 bis 24 Gew.-% n-Pentan umfasst.

5. Verfahren nach einem der Ansprüche 1 bis 3, **dadurch gekennzeichnet, dass** das Kältemittelfluid 75 bis 85 Gew.-% 1,1,1,3,3-Pentafluorpropan und 15 bis 25 Gew.-% Isopentan umfasst.

6. Verfahren nach einem der Ansprüche 1 bis 3, **dadurch gekennzeichnet, dass** das Kältemittelfluid 72 bis 80 Gew.-% 1,1,1,3,3-Pentafluorpropan und 20 bis 28 Gew.-% Cyclopentan umfasst.

## Claims

1. Heat transfer process using a compression system having at least one stage successively comprising a step of evaporation of a refrigerant fluid, a step of compression, a step of condensation of said fluid at a temperature between 70 and 140°C, preferably between 95 and 125°C, and a step of expansion of said fluid **characterized in that** the refrigerant fluid comprises from 60 to 95 wt% of 1,1,1,3,3-pentafluoropropane and from 5 to 40 wt% of at least one hydrocarbon chosen from n-pentane, isopentane and cyclopentane.

2. Process according to Claim 1, **characterized in that** the refrigerant fluid comprises from 66 to 93 wt% of 1,1,1,3,3-pentafluoropropane and from 7 to 34 wt% of at least one hydrocarbon chosen from n-pentane, isopentane and cyclopentane.

3. Process according to Claim 1 or 2, **characterized in that** the hydrocarbon is isopentane.

4. Process according to any one of Claims 1 to 3, **characterized in that** the refrigerant fluid comprises from 76 to 91 wt% of 1,1,1,3,3-pentafluoropropane and from 9 to 24 wt% of n-pentane.

5. Process according to any one of Claims 1 to 3, **characterized in that** the refrigerant fluid comprises from 75 to 85 wt% of 1,1,1,3,3-pentafluoropropane and from 15 to 25 wt% of isopentane.

6. Process according to any one of Claims 1 to 3, **characterized in that** the refrigerant fluid comprises from 72 to 80 wt% of 1,1,1,3,3-pentafluoropropane and from 20 to 28 wt% of cyclopentane.
